# EUROPEAN PATENT SPECIFICATION

(11) **EP 0 507 387 B1**
(45) Date of publication and mention of the grant of the patent: **27.12.1995**
(21) Application number: 92200864.4
(22) Date of filing: 26.03.1992
(51) Int. Cl.: H01L 21/00

(54) **Device for heating chemical tanks**
Heizungsanlage für chemische Behälter
Dispositif de chauffe pour cuves chimiques

(30) Priority: 05.04.1991 IT MI910947
(43) Date of publication of application: 07.10.1992
(73) Proprietor: SGS-THOMSON MICROELECTRONICS s.r.l., 20041 Agrate Brianza (Milano) (IT)
(72) Inventor: Scarpa, Cirino, I-96016 Lentini (Siracusa) (IT); Musco, Giuseppe, I-96016 Lentini (Siracusa) (IT); Falzone, Alberto, I-95022 Aci Catena (Catania) (IT)
(74) Representative: Mittler, Enrico

(56) References cited:
- EP-A- 0 385 382
- US-A- 4 841 645

## Description

The present invention relates to a method and a device for heating a chemical solution in a chemical tank.

In microelectronics the etching of silicon slices takes place by immersing them in a solution, such as for example a heated mixture of dilute hydrofluoric acid and ammonium fluoride in the proportion of one to seven by volume. Twentyfour litres of solution must be maintained within the temperature range from twentyeight to thirtyeight degrees Celsius, with a tolerance of plus or minus one degree Celsius, according to the type of process to which the silicon is subjected.

The heating of the mixture, always according to the known art, takes place through the use of teflon-coated electrical resistances, or of corrugated coils made of teflon both immersed in the solution. The coils use as the heating element hot water generated by automatic external heaters. A temperature sensor immersed in the solution controls the external heater so as to maintain the desired temperature of the solution.

The application of the systems described above has some drawbacks.

As far as the heating systems based on teflon-coated resistances are concerned it should in fact be noted that with use and handling due to cleaning the protective coating deteriorates and microfractures are created in the teflon coating which place the etching solution directly in contact with the metal of the resistance. As a consequence, the solution is contaminated with metal ions.

As far as the heating systems based on hot-water coils are concerned, here again with use and handling due to cleaning microfractures are created in the corrugated coil made of teflon, and through the microfractures, there are infiltrations of heating water in the etching solution which is thus contaminated with ions of different kinds present in the water itself.

The contaminating ions thus introduced into the solution by the heating systems described above go and deposit themselves on the silicon slices contained in the etching tank damaging its integrity and increasing rejects occasionally in a significant manner.

US-A-4,841,645 discloses a vapor dryer system for electronic device substrates, comprising a tank with a reservoir for a solvent, a heat-exchanger coil immersed in the reservoir for heating the solvent. The coil is fed with ethylene glycol, which is heated by an external heater.

The object of the present invention is to provide a method for heating the solution that is reliable and avoids any form of contamination.

Another object is to provide a heating method for enhancing the uniformity of the temperature of the solution.

Still another object is to provide an improved device for actuating said method.

According to the invention such objects are attained by a method as defined in claim 1.

According to the invention, a device for actuating said method is also provided as defined in claim 10.

By circulating a flow of inert gas in the coils, in the case of microfissures in the teflon coils, any infiltration of inert gas, such as, say, nitrogen, in the solution not only does not jeopardize the composition and the purity of the solution itself but also allows the immediate visualization of the microloss by the bubbling of the inert gas in the solution through the microfracture. In any case the silicon slices are not contaminated.

In particular the inert gas made to circulate in said at least one coil is pure nitrogen.

Instead of just one heat-exchanger coil there is the possibility of having two heat-exchanger coils through which pure nitrogen flow is fed at the inlet of the device.

At the inlet to said pair of coils there is connected a pair of heating units suitable for receving at one inlet nitrogen under pressure and for being driven by a control unit in a linear manner for maintaining an operating temperature of the solution and in an impulsive manner for the recovery of said operating temperature, respectively.

In this way the twin-coil system allows a very fine and stable adjustment of the temperature of the solution with maximum deviations in absolute values equal to half a degree Celsius.

Said control unit is also suitable for driving a pair of solenoid valves for controlling the flow of nitrogen at inlet into the pair of heating units and its possible interruption for switching the device off.

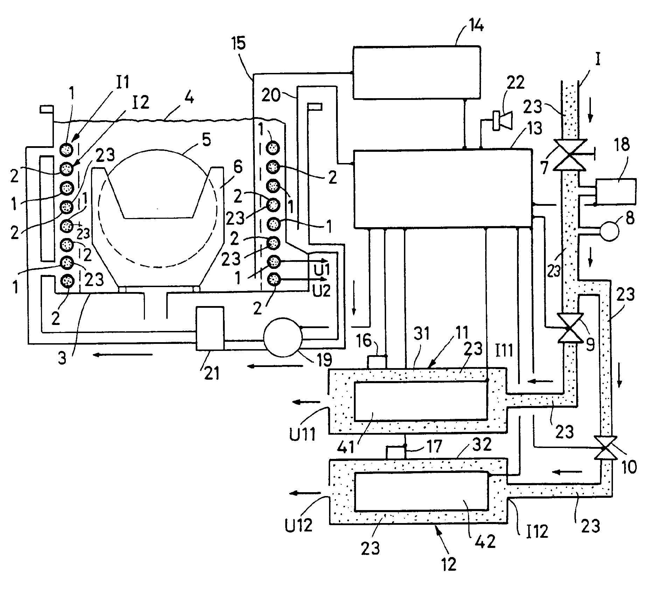

The features of the present invention shall be made more evident by the following detailed description of a device for actuating the method of the invention, which is illustrated as a non-limiting example in the single figure of the enclosed drawing.

With reference to the mentioned figure, a first and a second heat-exchanger coil 1, 2 are arranged and intercalated one with respect to the other in the proximity of the walls of a chemical tank 3 containing a solution 4 suitable for etching silicon slices 5 (only one shown in the drawing) in turn contained in corresponding containers 6. This solution can for example be a mixture of HF (hydrofluoric acid) and NH⁴F (ammonium fluoride) in the proportion of one to seven by volume and must for this purpose be maintained within a given temperature interval. In the particular case, twentyfour litres of the solution must be maintained within the temperature range from twentyeight to thirtyeight degrees Celsius with a tolerance of plus or minus one degree Celsius.

The coils 1, 2 are made of teflon and are traversed by a flow of pure nitrogen 23 fed in at an inlet I to the device.

Immediately downstream from the inlet I there is a pressure regulator 7 of the nitrogen 23 and a pressure switch 18 measuring the pressure itself.

In succession there is a pair of solenoid valves 9, 10 suitable for regulating the flow of nitrogen 23 and for feeding it to respective inlets I11, I12 of a first and of a second heating unit 11, 12, whose outlets U11, U12 feed the coils 1, 2. Each heating unit 11, 12 consists of a shell 31, 32 having a cylindrical shape which houses electrical resistances 41, 42 inside it having the function of heating the flow of nitrogen 23 to the preset temperature.

The device also comprises a control logic 13. The control logic 13 is connected to a temperature controller 14 suitable for receiving from a thermocouple 15 signals related to the temperature of the solution 4 and for sending to the logic 13 a signal equal to the deviation between the detected temperature and the preset temperature.

The control logic 13 is also connected to the solenoid valves 9, 10 for controlling and possibly interrupting the flow of nitrogen 23 toward the first and second heating units 11, 12. It is also connected to the first and second heating units 11, 12 themselves. In particular the first heating unit 11, connected to the first coil 1, is suitable for being driven by the control unit 13 in a linear manner for maintaining the preset temperature in the solution 4, while the second heating unit 12, connected to the second coil 2, is suitable for being driven by the control unit 13 in an impulsive manner for the prompt recovery of the set temperature in the case of a lowering of the temperature of the solution 4 at the moment when the container 6 with the slices 5 to be processed is introduced.

The set of two independent drives (linear and impulsive) of the heating units 11 and 12 allows a uniform temperature of the solution 4 to be obtained with maximum deviations in absolute values equal to half a degree Celsius.

Between the control logic 13 and the heating units 11, 12 there are also interposed safety control means 16, 17 of excess temperature, which intervene in case of anomalies in the heating elements 11, 12.

To the control unit 13 there is connected a safety pressure switch 18 inserted in the line feeding nitrogen to the solenoid valves 9, 10 and suitable for transmitting to the control unit 13 a signal for automatically switching the heating units 11, 12 off in case of a pressure fall of the nitrogen 23 in the line so as not to damage the heating elements 11, 12 themselves.

The tank 3 is provided with a pump 19 having a corresponding filter 21 for the filtered recirculation of the solution 4 and with an associated level control 20 connected at the inlet to the control unit 13 and suitable for stopping the recirculation pump in case of an excessive lowering of the solution 4.

The control unit 13 is lastly provided with an alarm device 22 suitable for providing the operator with an acoustical signal in case of malfunctions in the device.

Initially a container 6 with one or more silicon slices 5 to be processed is positioned on the bottom of the tank 3, filled with a solution 4 for example of the type described above. Then nitrogen 23 is fed at the inlet I of the device and taken to a given pressure through the pressure regulator 7.

Following the path indicated by the arrows, the nitrogen 23 flows through the solenoid valves 9, 10, which, driven by the control unit 13, adjust its flow at input to the heating units 11, 12.

At the same time, the control unit 13, taking into account the figures related to the temperature deviations originating from the temperature controller 14, drives, in the manner described above, the operation of the heating units 11, 12. In particular, with the exclusion of an initial transitory, the heating unit 11 is operated in a linear manner for maintaining the preset temperature in the solution 4, while the heating unit 12 is driven in an impulsive manner for compensating temperature falls in the solution 4 such as those that take place during the introduction of one or more containers 6 with the silicon slices 5 to be processed. The nitrogen 23 flowing through the heating units 11, 12 is thus heated up to the outlets U11, U12 and is then introduced into the coils at respective inlets I11, I12. During circulation in the coils 1, 2, the nitrogen cools down and gives up heat to the solution 4.

During the operation of the device the temperature of the heating units 11, 12 is also kept under control by the safety control means 16, 17. Any anomalies are immediately signalled to the control unit 13, which with the buzzer 22 signals the anomaly to the operator.

In a similar fashion the safety pressure switch 18 controls the pressure of the nitrogen 23 and in case of a sudden fall it transmits a signal to the control unit 13 suitable for causing the heating units 11, 12 to be switched off automatically and for signalling the anomaly with the buzzer 22.

In addition, by means of the pump 19 with the corresponding filter 21 there is a continuous filtered recirculation of the solution 4, that is, however, stopped in case the level of the solution 4 is lowered as transmitted by the level controller 20 to the control unit 13 and signalled to the operator by the buzzer 22.

It should be noted that the method and device of the invention, in addition to allowing the heating of a solution contained in a chemical tank with minimum heat deviations, also assure that in case of microlosses of the coils, the composition and the purity of the solution are not jeopardized, and are such microlosses are immediately visualized by the bubbling of the nitrogen.

Thus the method and device described can be used in all those applications where a controlled heating of solutions is required, without running the risk of contaminating the solutions themselves.

To the embodiment described it is naturally possible to make numeous variants without going outside the scope of the claimed invention. For example, it is possible to provide more than two heat-exchanger coils, connected to an equal number of heating units, according to the mass to be heated and to the temperature of the solution.

## Claims

1. Method for heating a chemical solution (4) in a chemical tank (3) in which at least one heat-exchanger coil (1,2) is immersed, characterized in that a flow of an inert gas (23) is made to circulate in said at least one heat-exchanger coil (1,2).

2. Method according to claim 1, characterized in that said inert gas (23) is pure nitrogen.

3. Method according to claim 1, characterized in that said at least one coil (1,2) comprises at least one pair of coils, intercalated one with respect to the other, and inert gas (23) under pressure is fed thereto through respective heating units (11,12) which are driven by a control unit (13) in a linear manner for maintaining an operating temperature of the solution (4), and in an impulsive manner for the recovery of said operating temperature, respectively.

4. Method according to claim 3, characterized in that said control unit (13) drives a pair of solenoid valves (9,10) for controlling the flow of inert gas (23) at respective inlets of the pair of heating units (11,12), and when necessary for interrupting said flow of inert gas (23).

5. Method according to claim 3, characterized in that it provides for detecting the temperature of the solution (4) by means of a temperature sensor (15) in the solution (4), and for signalling said detected temperature to a temperature controller (14) suitable for transmitting the variation of the detected temperature with respect to a preset temperature to said control unit (13).

6. Method according to claim 3, characterized in that it provides for feeding said heating units (11,12) with inert gas (23) at a prescribed pressure from a supply line by means of a pressure regulator (7).

7. Method according to claim 6, characterized in that it provides for controlling the pressure of the inert gas (23) in the supply line by means of a pressure switch (18) operatively coupled to said control unit (13), and for switching the heating units (11,12) off when said pressure in the supply line falls.

8. Method according to claim 3, characterized by providing for controlling the temperature of the heating units (11,12) by means of safety control means (16,17), and for switching the heating units (11,12) off in case of excess temperature.

9. Device for heating a chemical solution in a chemical tank, comprising at least one heat-exchanger coil (1,2) located inside said chemical tank (3) and immersed in the chemical solution (4), characterized in that said at least one heat-exchanger coil (1,2) comprises a first and a second heat-exchanger coil (1,2) intercalated one to the other, and in that the device further comprises:
- means (7,9,10) for supplying an inert gas (23) at a prescribed pressure from an inert gas supply line through respective first and second gas heating units (11,12);
- thermal sensor means (15,14) for detecting a temperature of the solution (4) and for comparing the detected temperature with a preset temperature;
- a control unit (13) operatively connected to said thermal sensor means (15,14) and to said first and second heating units (11,12) for driving the first heating unit (11) in a linear manner to maintain the temperature of the solution (4) at the preset temperature, and for driving the second heating unit (12) in an impulsive manner to promptly recover the preset temperature of the solution (4).

10. Device according to claim 9, characterized in that said means (7,9,10) for supplying the inert gas (23) comprise a pressure regulator (7) connected between said inert gas supply line and the heating units (11,12), for supplying inert gas (23) at a prescribed pressure, and a pair of solenoid valves (9,10) driven by said control unit (13) for controlling the flow of the inert gas (23) at the inlet of the first and second heating units (11,12), respectively, and for interrupting said inert gas (23) flow when the apparatus is switched off.

11. Device according to claim 10, characterized in that it comprises a pressure switch (18) operatively connected to the control unit (13) for detecting the pressure of the inert gas (23) and signalling to the control unit (13) to switch the heating units (11,12) off in the case of a pressure drop.

12. Device according to claim 9, characterized in that each of said heating units (11,12) comprises a shell housing electrical resistances suitable to heat the inert gas (23).

13. Device according to claim 9, characterized in that it further comprises safety control means (16,17) associated to each heating unit (11,12) for switching the heating units (11,12) off when detecting an excessive temperature.

## Patentansprüche

1. Verfahren zum Aufheizen einer chemischen Lösung (4) in einem chemischen Tank (3), in den mindestens eine Wärmetauscherspule (1, 2) eingetaucht ist, dadurch gekennzeichnet, daß ein Inertgasstrom (23) in der mindestens einen Wärmetauscherspule (1, 2) zum Zirkulieren gebracht wird.

2. Verfahren nach Anspruch 1, dadurch gekennzeichnet, daß das Inertgas (23) reiner Stickstoff ist.

3. Verfahren nach Anspruch 1, dadurch gekennzeichnet, daß die mindestens eine Spule (1, 2) mindestens ein Paar von Spulen umfaßt, die ineinandergefügt sind, und daß ihnen unter Druck stehendes Inertgas (23) über zugehörige Heizeinheiten (11, 12) zugeführt wird, welche von einer Steuereinheit (13) getrieben werden, und zwar in linearer Weise, um eine Betriebstemperatur der Lösung (4) beizubehalten, und impulsweise, um die Betriebstemperatur wiederzuerlangen.

4. Verfahren nach Anspruch 3, dadurch gekennzeichnet, daß die Steuereinheit (13) ein Paar Magnetventile (9, 10) zum Steuern des Inertgasstromes (23) an zugehörigen Einlässen des Paares von Heizeinheiten (11, 12) und - bei Bedarf - zum Unterbrechen des Inertgasstromes (23) treibt.

5. Verfahren nach Anspruch 3, dadurch gekennzeichnet, daß die Temperatur der Lösung (4) mit Hilfe eines Temperaturfühlers in der Lösung (4) erfaßt wird und die erfaßte Temperatur einer Temperatursteuerung (14) übermittelt wird, die dazu ausgelegt ist, die Änderung der erfaßten Temperatur in bezug auf eine voreingestellte Temperatur der Steuereinheit (13) zu übersenden.

6. Verfahren nach Anspruch 3, dadurch gekennzeichnet, daß die Heizeinheiten (11, 12) mit Inertgas (23) eines vorbestimmten Druckes über eine Versorgungsleitung mit Hilfe eines Druckreglers (7) gespeist werden.

7. Verfahren nach Anspruch 6, dadurch gekennzeichnet, daß der Druck des Inertgases (23) in der Versorgungsleitung mit Hilfe eines Druckschalters (18) gesteuert wird, welcher betrieblich mit der Steuereinheit (13) gekoppelt ist, und daß die Heizeinheiten (11, 12) abgeschaltet werden, wenn der Druck in der Versorgungsleitung abfällt.

8. Verfahren nach Anspruch 3, dadurch gekennzeichnet, daß die Temperatur der Heizeinheiten (11, 12) mit Hilfe einer Sicherheitssteuereinrichtung (16, 17) gesteuert wird, und daß die Heizeinheiten (11, 12) im Fall einer überhöhten Temperatur abgeschaltet werden.

9. Vorrichtung zum Erhitzen einer chemischen Lösung in einem chemischen Tank, umfassend mindestens eine Wärmetauscherspule (1, 2) im Inneren des chemischen Tanks (3) und eingetaucht in die chemische Lösung (4), dadurch gekennzeichnet, daß mindestens eine Wärmetauscherspule (1, 2) eine erste und eine zweite Wärmetauscherspule (1, 2) aufweist, die ineinandergesetzt sind, und daß die Vorrichtung außerdem aufweist:
- eine Einrichtung (7, 9, 10) zum Zuführen eines Inertgases (22) eines vorbestimmten Drucks aus einer Inertgasversorgungsleitung über eine erste bzw. eine zweite Gasheizeinheit (11, 12);
- eine Wärmefühlereinrichtung (15, 14) zum Erfassen einer Temperatur der Lösung (4) und zum Vergleichen der erfaßten Temperatur mit einer voreingestellten Temperatur;
- eine Steuereinheit (13), die betrieblich mit der Wärmefühlereinrichtung (15, 14) und der ersten und der zweiten Heizeinheit (11, 12) verbunden ist, um die erste Heizeinheit (11) in linearer Weise zum Halten der Temperatur der Lösung (4) auf der voreingestellten Temperatur zu treiben, und um die zweite Heizeinheit (12) im Impulsbetrieb zu treiben, um die voreingestellte Temperatur der Lösung (4) rasch wiederzuerlangen.

10. Vorrichtung nach Anspruch 9, dadurch gekennzeichnet, daß die Einrichtung (7, 9, 10) zum Zuführen des Inertgases (23) einen Druckregler (7) aufweist, der zwischen die Inertgas-Versorgungsleitung und die Heizeinheiten (11, 12) geschaltet ist, um Inertgas (23) unter einem vorbestimmten Druck zuzuführen, und ein Paar Magnetventile (9, 10) aufweist, die von der Steuereinheit (13) zum Steuern des Inertgasstroms (23) am Einlaß der ersten bzw. der zweiten Heizeinheit (11, 12) und zum Unterbrechen des Inertgasstroms (22), wenn das Gerät ausgeschaltet wird, getrieben werden.

11. Vorrichtung nach Anspruch 10, dadurch gekennzeichnet, daß sie einen Druckschalter (18) aufweist, der betrieblich an die Steuereinheit (13) angeschlossen ist, um den Druck des Inertgases (23) zu erfassen und der Steuereinheit (13) zu signalisieren, die Heizeinheiten (11, 12) im Fall eines Druckabfalls auszuschalten.

12. Vorrichtung nach Anspruch 9, dadurch gekennzeichnet, daß jede der Heizeinheiten (11, 12) eine Umhüllung aufweist, die elektrische Widerstände zum Erhitzen des Inertgases (23) enthält.

13. Vorrichtung nach Anspruch 9, dadurch gekennzeichnet, daß sie außerdem zu jeder Heizeinheit (11, 12) gehörige Sicherheitssteuermittel (16, 17) aufweist, um die Heizeinheiten (11, 12) auszuschalten, wenn eine überhöhte Temperatur erfaßt wird.

## Revendications

1. Procédé pour chauffer une solution chimique (4) dans une cuve chimique (3) dans laquelle au moins un serpentin échangeur de chaleur (1, 2) est immergé, caractérisé en ce qu'un flux d'un gaz inerte (23) est créé dans ledit au moins un serpentin échangeur de chaleur (1, 2).

2. Procédé selon la revendication 1, caractérisé en ce que ledit gaz inerte (23) est de l'azote pur.

3. Procédé selon la revendication 1, caractérisé en ce que ledit au moins un serpentin (1, 2) comprend au moins une paire de serpentins, entremêlés l'un dans l'autre, et alimentés en un gaz inerte (23) sous pression par des modules de chauffage respectifs (11, 12) qui sont commandés par un module de commande (13), respectivement de façon linéaire pour maintenir une température de fonctionnement de la solution (4), et par impulsions pour rétablir ladite température de fonctionnement.

4. Procédé selon la revendication 3, caractérisé en ce que ledit module de commande (13) commande une paire d'électrovannes (9, 10) pour réguler le flux du gaz inerte (23) à des entrées respectives de la paire de modules de chauffage (11, 12), et le cas échéant pour interrompre ledit flux de gaz inerte (23).

5. Procédé selon la revendication 3, caractérisé en ce qu'il prévoit la détection de la température de la solution (4) au moyen d'un détecteur de température (15) placé dans la solution (4), et l'indication de ladite température détectée à un dispositif de contrôle de température (14) susceptible de transmettre audit module de commande (13) la variation de la température détectée par rapport à une température préréglée.

6. Procédé selon la revendication 3, caractérisé en ce qu'il prévoit l'alimentation des modules de chauffage (11, 12) en un gaz inerte (23) à une pression prescrite par une conduite d'alimentation au moyen d'un régulateur de pression (7).

7. Procédé selon la revendication 6, caractérisé en ce qu'il prévoit le contrôle de la pression du gaz inerte (23) dans la conduite d'alimentation au moyen d'un commutateur de pression (18) couplé audit module de commande (13), et l'arrêt des modules de chauffage (11, 12) lorsque ladite pression dans la conduite d'alimentation chute.

8. Procédé selon la revendication 3, caractérisé en ce qu'il prévoit le contrôle de la température des modules de chauffage (11, 12) au moyen d'un dispositif de contrôle de sécurité (16, 17), et l'arrêt des modules de chauffage (11, 12) en cas de température excessive.

9. Dispositif de chauffage d'une solution chimique dans une cuve, comprenant au moins un serpentin échangeur de chaleur (1, 2) placé dans ladite cuve (3) et immergé dans la solution chimique (4), caractérisé en ce que ledit au moins un serpentin échangeur de chaleur (1, 2) comprend un premier et un second serpentin échangeur de chaleur (1, 2) entremêlés l'un dans l'autre, et en ce que le dispositif comprend en outre :
- des moyens (7, 9, 10) pour fournir un gaz inerte (23) à une pression définie à partir d'une conduite d'alimentation de gaz inerte par l'intermédiaire de premier et second modules de chauffage du gaz (11, 12);
- des moyens (15, 14) de détection thermique pour déterminer la température de la solution (4) et la comparer à une température préréglée ;
- un module de commande (13) connecté auxdits moyens de détection thermique (15, 14) et auxdits premier et second modules de chauffage (11, 12) pour commander le premier module de chauffage (11) de façon linéaire pour maintenir la température de la solution (4) à la température préréglée, et pour commander le second module de chauffage (12) par impulsions pour rétablir rapidement la température préréglée de la solution (4).

10. Dispositif selon la revendication 9, caractérisé en ce que lesdits moyens (7, 9, 10) d'alimentation en gaz inerte (23) comprennent un régulateur de pression (7) interposé entre ladite conduite d'alimentation en gaz inerte et les modules de chauffage (11, 12), pour fournir un gaz inerte (23) à une pression prescrite, et une paire d'électrovannes (9, 10) commandées par ledit module de commande (13) pour réguler le flux du gaz inerte (23) respectivement aux entrées des premier et second modules de chauffage (11, 12), et pour interrompre ledit flux de gaz inerte (23) lorsque le dispositif est arrêté.

11. Dispositif selon la revendication 10, caractérisé en ce qu'il comprend un commutateur de pression (18) connecté au module de commande (13) pour détecter la pression du gaz inerte (23) et pour signaler au module de commande (13) d'arrêter les modules de chauffage (11, 12) en cas de chute de pression.

12. Dispositif selon la revendication 9, caractérisé en ce que chacun desdits modules de chauffage (11, 12) comprend des résistances électriques logées dans un boîtier et adaptées au chauffage du gaz inerte (23).

13. Dispositif selon la revendication 9, caractérisé en ce qu'il comprend en outre des moyens de contrôle de sécurité (16, 17) associés à chaque module de chauffage (11, 12) pour couper lesdits modules de chauffage (11, 12) lorsqu'une température excessive est détectée.
